# EUROPEAN PATENT APPLICATION

(11) **EP 4 645 368 A1**
(43) Date of publication of application: **05.11.2025**
(21) Application number: 24821726.7
(22) Date of filing: 08.03.2024

(54) **THIN FILM TRANSISTOR INCLUDING CARBON NANOTUBE CHANNEL LAYER AND MANUFACTURING METHOD THEREFOR**

(30) Priority: 07.03.2024 KR 20240032417
(71) Applicant: Seoul National University R&DB Foundation, Seoul 08826 (KR)
(72) Inventor: HONG, Yong Taek, Gwanak-gu Seoul 08826 (KR); KIM, Ha Yun, Gwanak-gu Seoul 08826 (KR); KIM, Jae Hak, Gangnam-gu Seoul 06267 (KR)
(74) Representative: TRBL Intellectual Property
(86) International application number: PCT/KR2024/003023
(87) International publication number: WO 2025/187853

(57) **Abstract**

The thin film transistor comprising a carbon nanotube channel layer proposed in one example of the present invention comprises a substrate; a source electrode and a drain electrode formed on the substrate; a first channel layer comprising a first carbon nanotube located between the source electrode and the drain electrode; and a second channel layer comprising a second carbon nanotube formed on a portion of the first channel layer.

## Description

### [TECHNICAL FIELD]

The present invention relates to a thin film transistor comprising a carbon nanotube channel layer and a display device equipped with a circuit comprising a thin film transistor using the same, and a manufacturing method of a thin film transistor comprising a carbon nanotube channel layer.

### [BACKGROUND ART]

Carbon nanotubes are carbon isotopes with cylindrical nanostructures, and have excellent electrical conductivity and thermal conductivity, and have excellent flexibility, so they can be applied to flexible electronic elements and devices. They are largely divided into single walled carbon nanotubes and multi walled carbon nanotubes, and the multi walled carbon nanotubes have a characteristic of higher mechanical strength than the single walled carbon nanotubes.

Recently, the flexible display market has been growing, and carbon nanotube materials are attracting attention as a key material for flexible displays because they can operate and stand on flexible and stretchable substrates due to their flexibility. Among them, transistors based on the carbon nanotube random network have problems in that they have low on current and therefore, it is difficult to commercialize them. In order to solve them, there have been attempts to increase the low on current by controlling the areal coverage of the single walled carbon nanotubes, but there have been limitations that cannot improve performance beyond a certain level due to problems such as the margin of increase of the off current increases than the margin of increase of the on current and the like.

Therefore, there is a need for a transistor device technology using carbon nanotubes that has a low margin of increase of the leakage current, without requiring a separate structural change to the conventional channel layer.

### [DISCLOSURE]

### [TECHNICAL PROBLEM]

The object of the present invention is to solve the afore-mentioned problems, and is to propose a technology of a thin film transistor with improved performance by forming a modified carbon nanotube channel layer on the channel of the thin film transistor.

Other examples suggested in the present invention have as one object proposing a display device driven by a circuit comprising the thin film transistor having the advantages described above and a manufacturing method of the thin film transistor.

However, problems to be solved by the present invention are not limited to those mentioned above, and other problems not mentioned can be clearly understood to those skilled in the art from the following description.

### [TECHNICAL SOLUTION]

In order to solve the afore-mentioned problems, the thin film transistor comprising a carbon nanotube channel layer proposed in one aspect of the present invention comprises a substrate; a source electrode and a drain electrode formed on the substrate; a first channel layer comprising a first carbon nanotube located between the source electrode and the drain electrode; and a second channel layer comprising a second carbon nanotube formed on a portion of the first channel layer.

According to one example, the first carbon nanotube may have lower conductivity than the second carbon nanotube.

According to one example, the first carbon nanotube and the second carbon nanotube may be single walled carbon nanotubes, and the first channel layer and the second channel layer may form a network structure.

According to one example, the first channel layer may have a semiconducting property, and the second channel layer may have a metallic property.

According to one example, the purity of the metallic carbon nanotube of the second channel layer may be higher than the purity of the metallic carbon nanotube of the first channel layer.

According to one example, the second channel layer may have a narrower bandgap than the first channel layer.

According to one example, the purity of the metallic carbon nanotube of the second channel layer may be 60 wt% to 90 wt%.

According to one example, the second channel layer is formed to have a shorter length than the first channel layer in the central part of the first channel layer.

According to one example, the length of the second channel layer may be 50% to 90% of the length of the first channel layer.

The display device equipped with a circuit comprising the thin film transistor suggested in another aspect of the present invention comprises an insulating layer formed on a substrate; and a pixel circuit array formed on the insulating layer.

According to one example, the array may comprise a thin film transistor circuit comprising a carbon nanotube channel.

According to one example, the insulating layer may comprise at least one selected from the group consisting of PVP (polyvinylphenol), PVA (polyvinylalcohol), PMMA (polymethyl methacrylate), PVDF (Poly vinylidene fluoride), PVDF-TrFE (Poly vinylidene fluoride-trifluoroethylene), PVDF-HFP (Poly vinylidene fluoride-co-hexafluoropropylene) and SEBS (Styrene Ethylene/Butylene Styrene).

According to one example, the thin film transistor comprising a carbon nanotube channel layer may be the thin film transistor comprising the carbon nanotube channel layer.

The manufacturing method of a thin film transistor comprising a carbon nanotube channel layer proposed in other one aspect of the present invention comprises forming an oxide layer on a substrate; forming a first channel layer comprising a single walled carbon nanotube network on the upper part of the oxide layer; forming a second channel layer comprising a metallic carbon nanotube on the first channel layer; and forming a source electrode and a drain electrode on the oxide layer.

According to one example, the forming a first channel layer and the forming a second channel layer may be performed by an inkjet printing process.

According to one example, the carbon nanotube comprised in the second channel layer may be a single walled carbon nanotube network, and the forming a first channel layer and the forming a second channel layer may increase the carbon nanotube network density of the channel layer by repeatedly performing a unit process consisting of an inkjet printing process and a cleaning process multiple times.

According to one example, the carbon nanotube thin film transistor may be the carbon nanotube thin film transistor of claim 1.

### [ADVANTAGEOUS EFFECTS]

According to one example of the present invention, a transistor with a new structure can be proposed in which the on-off current ratio is improved by adding a metallic carbon nanotube to the channel layer of the transistor to increase the on-current while maintaining the off current.

The transistor suggested in one example of the present invention as above can be applied to flexible displays, and has an effect capable of contributing to commercialization of flexible displays by reducing flicker phenomena due to low leakage current.

However, the effect of the present invention is not limited to the effect described above, and the effect of the present invention includes all effects that are naturally implemented due to various configurations suggested in the contents described below.

### [BRIEF DESCRIPTION OF THE DRAWINGS]

FIG. 1 is a schematic diagram showing the configuration and mechanism of the thin film transistor comprising the carbon nanotube channel layer according to one example of the present invention.
FIG. 2 is a SEM measurement image of the carbon nanotube channel layer according to one example of the present invention.
FIG. 3 is a graph showing the relationship between the on-off current ratio and the mobility for the thin film transistor according to one example of the present invention and a conventional single walled carbon nanotube random network-based transistor.
FIG. 4 is a circuit, a circuit diagram and an optical image of a display device equipped with a circuit comprising the thin film transistor according to one example of the present invention.

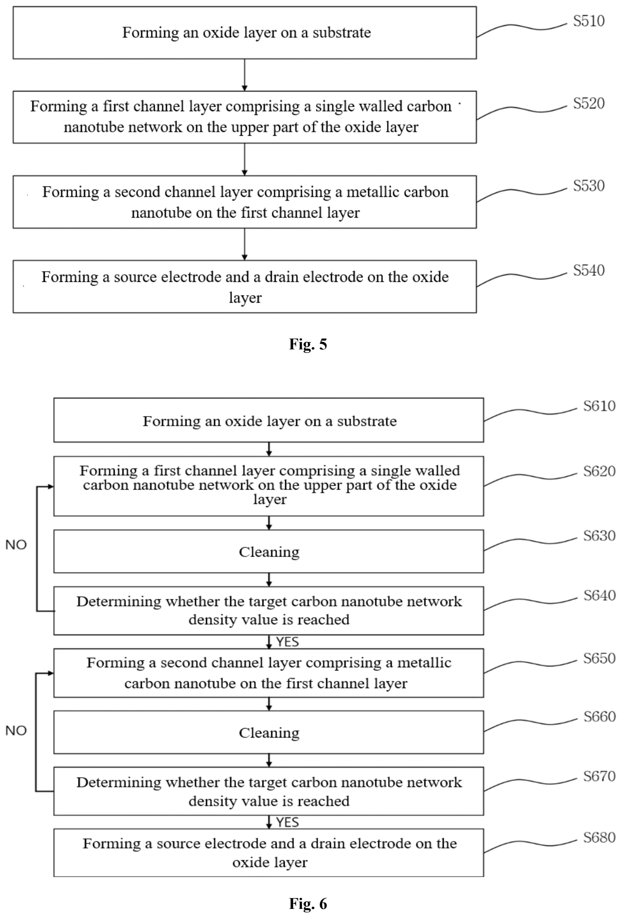

FIG. 5 is a flow chart showing the manufacturing method of the thin film transistor according to one example of the present invention.
FIG. 6 is a flow chart showing the manufacturing method of the thin film transistor according to one example of the present invention.
FIG. 7 is a graph showing a transfer curve according to the type of the channel layer of the thin film transistor.
FIG. 8 is a graph showing a transfer curve according to the length of the MAC region.
FIG. 9 is a graph showing a transfer curve according to the ink drop density (DD).
FIG. 10 is a graph showing a transfer curve of the transistor in which Ag is printed in the MAC region and the transistor according to one example of the present invention.
FIG. 11 is a graph showing a transfer curve of a single transistor and the transistor according to one example of the present invention.

### [MODE FOR INVENTION]

Examples of the present disclosure are illustrated for the purpose of describing the technical spirit of the present disclosure. The scope according to the present disclosure are not limited to examples presented below or specific description of these examples.

All technical terms and scientific terms used in the present disclosure have meanings commonly understood by those skilled in the art to which the present disclosure belongs, unless otherwise defined. All terms used in the present disclosure are selected for the purpose of more clearly describing the present disclosure, and are not selected to limit the scope according to the present invention.

Expressions such as "comprising", "providing", "having" and the like used in the present disclosure, should be understood in open-ended terms encompassing the possibility of including other examples, unless otherwise stated in a phrase or sentence in which the corresponding expression is included.

Expressions in a singular form described in the present disclosure may include a meaning of a plural form unless otherwise stated, and this is equally applied to expressions in a singular form described in claims.

Hereinafter, with reference to the attached drawings, examples of the present invention will be described. In addition, in the description of the following examples, repeated description of identical or corresponding components may be omitted. However, even if description of a component is omitted, it is not intended that such component is not included in any example.

The thin film transistor comprising a carbon nanotube channel layer according to one example of the present invention may comprise a substrate; a source electrode and a drain electrode formed on the substrate; a first channel layer comprising a first carbon nanotube located between the source electrode and the drain electrode; and a second channel layer comprising a second carbon nanotube formed on at least a portion of the first channel layer.

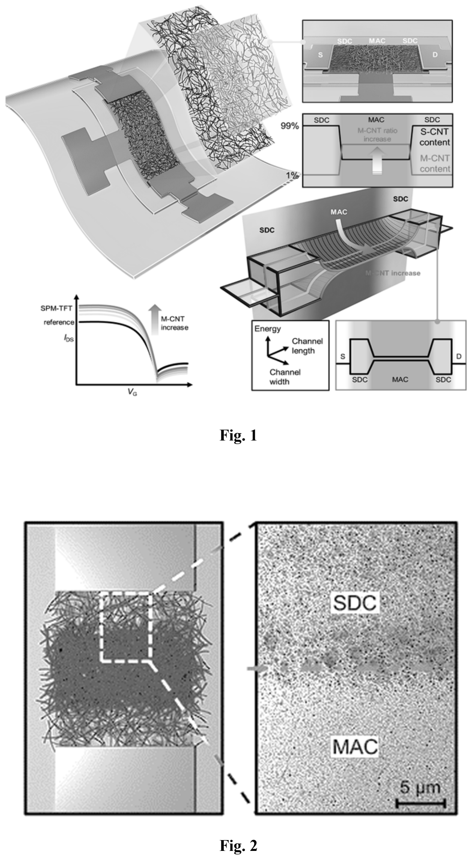

FIG. 1 is a schematic diagram showing the configuration and mechanism of the thin film transistor comprising the carbon nanotube channel layer according to one example of the present invention.

According to one example, carbon nanotubes may have different conductivity depending on the diameter of the tubes. In addition, the conductivity may vary depending on chirality. Therefore, carbon nanotubes may be divided into metallic carbon nanotubes, semiconducting carbon nanotubes, and non-conductive carbon nanotubes.

According to one example, the channel comprising carbon nanotubes may comprise a metallic carbon nanotube and a semiconducting carbon nanotube. As one embodiment, the semiconducting carbon nanotube of the purity of 90 wt% may be a metallic carbon nanotube of the purity of 10 wt%.

Carbon nanotubes can be divided into single walled carbon nanotubes (SWCNT, Single walled CNT) and multi walled carbon nanotubes (MWCNT, Multi Walled CNT) depending on the number of walls of carbon nanotubes. In addition, the single walled carbon nanotubes can be divided into semiconducting single walled carbon nanotubes (S-CNT, Semiconducting SWCNT) and metallic single walled carbon nanotubes (M-CNT, Metallic SWCNT) according to chiral properties. As one embodiment, a single walled carbon nanotube with high carrier mobility may be used for the channel of the transistor. As one embodiment, the first carbon nanotube or the second carbon nanotube may be a single walled carbon nanotube. As one embodiment, the diameter of the single walled carbon nanotube may be 1nm to 2nm. In addition, the length of the single walled carbon nanotube may be 0.1µm to 1.5µm.

According to one example, the second channel layer may be formed on at least a portion of the first channel layer. In one embodiment, the second channel layer may be formed in a smaller region than the first channel layer, and in another embodiment, it may be formed in a form that covers almost all of the first channel layer. The region in which the second channel layer is formed may be called an MAC (M-CNT added channel) region, and the region in which the second channel layer is not formed on the first channel layer may be called an SDC (S-CNT dominant channel) region. Referring to FIG. 1, it can be confirmed that the SDC region maintains high-purity semiconducting single walled carbon nanotubes, and the MAC region has a higher ratio of metallic single walled carbon nanotubes.

According to one example, the metallic single walled carbon nanotubes of the MAC region may form more percolation pathways to gradually narrow bandgaps of the MAC region. On the other hand, the SDC region may show broader bandgaps due to the small number of metallic single walled carbon nanotubes. In addition, the anisotropic bandgap profile depending on the channel direction can induce a large voltage drop in the SDC region, and make the Schottky barrier between the source electrode and drain electrode and the channel thin, which can facilitate hole tunneling and transport in the on-state. With this, due to the wide bandgap and low content of metallic single walled carbon nanotubes of SDC, there is no carrier, and thus, electron injection can be effectively blocked and leakage current can be reduced.

It is a general method that a metallic single walled carbon nanotube is used as a material of a source electrode or drain electrode other than the channel layer, for the thin film transistor comprising a common carbon nanotube in the channel layer. An exemplary method expected from this perspective may include a technology for intentionally removing metallic carbon nanotubes among carbon nanotubes composing the channel layer, to increase the purity of semiconducting carbon nanotubes present in the channel layer.

On the other hand, the thin film transistor according to one example of the present invention is a technology of trying to increase performance by further adding a metallic carbon nanotube in the channel layer intentionally. This may be an attempt in a new direction that retrogresses conventional research directions.

According to one example, the first carbon nanotube may have lower conductivity than the second carbon nanotube. Accordingly, compared to the channel composed by only the first carbon nanotubes, the channel in which the second carbon nanotubes are formed on the first carbon nanotubes can achieve high on current performance by improving the conductivity of the entire channel.

FIG. 2 is a SEM measurement image of the carbon nanotube channel layer according to one example of the present invention. Referring to FIG. 2, a difference in carbon nanotube density between the SDC region and MAC region can be seen. This may be because ink with high purity of metallic single walled carbon nanotubes is further printed on the MAC region through an inkjet process.

According to one example, the first channel layer or the second channel layer may comprise a structure that carbon nanotubes form a network structure. The transistors using carbon nanotubes may be divided into single carbon nanotube transistors and carbon nanotube random network channel transistors. The carbon nanotube random network channel transistor may use not carbon nanotubes forming a random network but carbon nanotube strands. Compared to the single carbon nanotubes, the carbon nanotube random network channel transistor can maintain current in the off-state, since the leakage current in the off-state is a pA level.

According to one example, the first channel layer may have semiconducting properties. In addition, the second channel layer may have metallic properties. The second channel layer may comprise metallic carbon nanotubes, and may show better performance than the case of comprising silver (Ag) in the second channel layer. The better performance may mean a higher on/off current ratio (on/off ratio), which is a ratio of on current and off current. This may be because the contact resistance between the channel layers when the first channel layer comprises carbon nanotubes and the second channel layer comprises silver is higher than the contact resistance when both the first channel layer and the second channel layer comprise carbon nanotubes.

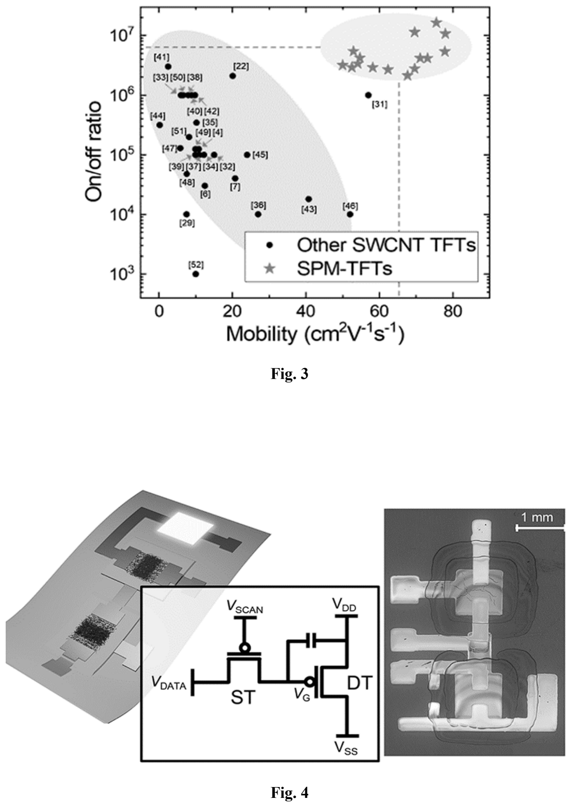

FIG. 3 is a graph showing the relationship between the on-off current ratio and the mobility for the thin film transistor according to one example of the present invention and a conventional single walled carbon nanotube random network-based transistor.

Referring to FIG. 3, the conventional single walled carbon nanotube random network-based transistor may show strong negative correlation between the mobility and on/off current ratio. On the contrary, the thin film transistor according to one example of the present invention may be outside the trade-off trend region. In addition, compared to the conventional single walled carbon nanotube random network, it may show the high mobility and on/off current ratio.

According to one example, the purity of the metallic carbon nanotubes of the second channel layer may be higher than the purity of the metallic carbon nanotubes of the first channel layer. In one embodiment, the first channel layer and the second channel layer comprising the carbon nanotubes may comprise both semiconducting carbon nanotubes and metallic carbon nanotubes and just contents thereof may be different. At this time, according to the example, the ratio of the semiconducting carbon nanotubes comprised by the first channel layer may be higher than the ratio of the semiconducting carbon nanotubes comprised by the second channel layer.

According to one example, the second channel layer may contain metallic carbon nanotubes at a higher ratio than semiconducting carbon nanotubes. It can be said that the purity of the metallic carbon nanotubes of the second channel layer is higher than the first channel layer. As one embodiment, the purity of the metallic carbon nanotubes of the second channel layer may be 60 wt% or more to 90 wt% or less. When the purity of the metallic carbon nanotubes of the second channel layer is 60 wt% or less, the increase in performance may be insignificant compared to when only the first channel layer is equipped. In addition, when the purity of the metallic carbon nanotubes is 90 wt% or more, a problem that the second channel layer cannot be formed may occur. This may be a problem caused by chemical bonds between each layer not being solid enough to form the second channel layer on the first channel layer.

According to one example, the MAC region may comprise metallic single walled carbon nanotubes in a sufficient amount capable of exceeding the percolation threshold. Accordingly, a spanning cluster may be formed. The spanning cluster may play a shortcut role for a carrier to move along the channel direction.

According to one example, the second channel layer may be formed to have a shorter length than the first channel layer in the central part of the first channel layer. Thus, only the semiconducting carbon nanotube channel layer may be formed in the contact portion of the channel and the source electrode and drain electrode. As only the semiconducting carbon nanotube channel layer is located in the contact portion, it can exhibit good off-state performance of the single walled carbon nanotubes. The good off-state performance may refer to low leakage current.

According to one example, the length of the second channel layer may be 50% to 90% based on the length of the first channel layer. As one embodiment, when the length of the second channel layer is less than 50% based on the length of the first channel layer, compared to the channel having only the first channel layer, the increase in performance may be insignificant. In addition, when the length of the second channel layer is over 90% based on the length of the first channel layer, off current control may not be possible. In other words, when the length of the second channel layer is less than 50% or over 90% based on the length of the first channel layer, the effect intended to be achieved by forming the MAC region on a part of the SDC region intended in the present invention may not be properly implemented.

FIG. 4 is a circuit, a circuit diagram and an optical image of a display device equipped with a circuit comprising the thin film transistor according to one example of the present invention. The display device may comprise an insulating layer formed on a substrate; and a pixel circuit array formed on the insulating layer. In addition, the array may comprise a thin film transistor comprising a carbon nanotube channel.

According to one example, the pixel circuit array may comprise an array composed of a group comprising two transistors and 1 capacitor. In addition, the substrate may be a flexible substrate. Furthermore, both the insulating layer and the pixel circuit array may be formed by an inkjet printing process.

According to one example, the thin film transistor may be a thin film transistor comprising the first channel layer and the second channel layer. The display device in which the thin film transistor is applied may have higher maximum brightness compared to a conventional technology, as it has relatively high on current. In addition, the display device has low leakage current, so the frequency of flicker issue occurrence may be reduced.

According to one example, the insulating layer may comprise at least one selected from the group consisting of PVP (polyvinylphenol), PVA (polyvinylalcohol), PMMA (polymethyl methacrylate), PVDF (Poly vinylidene fluoride), PVDF-TrFE (Poly vinylidene fluoride-trifluoroethylene), PVDF-HFP (Poly vinylidene fluoride-co-hexafluoropropylene) and SEBS (Styrene Ethylene/Butylene Styrene). Therefore, the insulating layer may be suitable for flexible substrates and devices.

The manufacturing method of a thin film transistor comprising a carbon nanotube channel layer according to one example of the present invention may comprise forming an oxide layer on a substrate; forming a first channel layer comprising a single walled carbon nanotube network on the upper part of the oxide layer; forming a second channel layer comprising a metallic carbon nanotube on the first channel layer; and forming a source electrode and a drain electrode on the oxide layer.

According to one example, the substrate may be a P-type doped silicon substrate. In addition, the oxide layer may be a dioxide layer. Before forming the first channel layer, in order to form a hydroxyl group on the oxide layer, UV ozone treatment may be performed on the substrate. After that, an amine-terminated surface may be formed by drop casting a PLL solution and cleaning the substrate with deionized water.

According to one example, the forming the first channel layer and the forming the second channel layer may be performed by an inkjet printing process. In addition, the carbon nanotubes comprised by the second channel layer may be a single walled carbon nanotube network. Furthermore, the carbon nanotubes comprised by the first channel layer may be single walled carbon nanotubes.

According to one example, by performing a cleaning process with deionized water after the inkjet printing process, weakly bound single walled carbon nanotubes and residual surfactants may be removed. The unit process consisting of the inkjet printing process and the cleaning process may be repeatedly conducted multiple times until the desired network density is reached.

According to one example, the forming the first channel layer and the second channel layer may comprise printing ink comprising semiconducting single walled carbon nanotubes with purity of 99 wt% first; and printing ink comprising metallic single walled carbon nanotubes with purity of 70 wt% in the central part of the channel. In addition, the metallic single walled carbon nanotubes with purity of 70 wt% may be additionally printed in the region in which the channel and the source electrode and drain electrode are bonded.

### (Examples)

Hereinafter, the effects of the thin film transistor according to one example of the present invention will be described by experimental results.

### (Experiment 1)

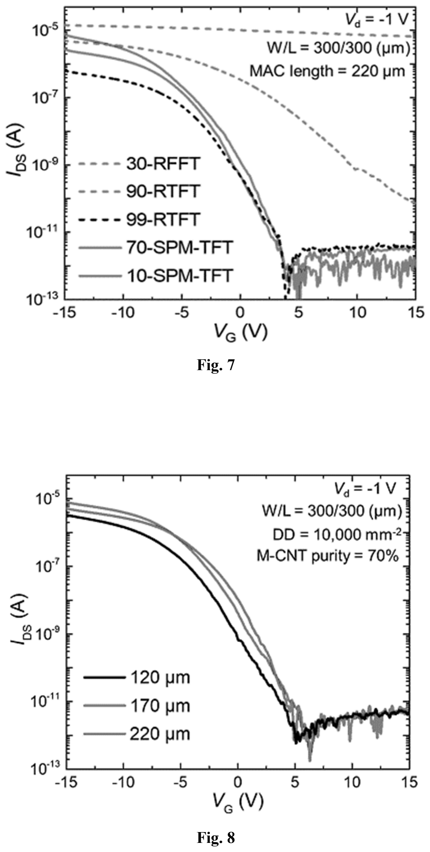

FIG. 7 is a graph showing a transfer curve according to the type of the channel layer of the thin film transistor.

Two kinds of the thin film transistors according to one example of the present invention and 3 kinds of devices having channels of uniform density and purity were compared. At first, devices were fabricated on p-type silicon wafers with a dioxide layer grown with a 200 nm thickness. The channel width and length were fixed each at 300µm.

As comparative examples, devices having channels of uniform density and purity, 99-RTFT, and 90-RTFT were fabricated by printing semiconducting single walled carbon nanotubes with the purity of 99 wt% and 90 wt%, respectively. In addition, 30-RTFT was manufactured by printing metallic single walled carbon nanotubes of the purity with 70 wt% in the entire channel region.

On the other hand, the thin film transistors according to one example of the present invention, 70-SPM-TFT and 10-SPM-TFT formed an SDC region using a semiconducting single walled carbon nanotube of the purity of 99 wt% and formed an MAC region using metallic single walled carbon nanotubes with the purity of 10 wt% and the purity of 70 wt%.

In addition, as an additional comparative example, a thin film transistor under the same conditions except for forming the MAC region using Ag was prepared.

For the 6 kinds of the transistors, the mobility, on current (Iₒₙ), on-off current ratio (log₁₀(Iₒₙ/I_{off})), off current (I_{off}), subthreshold value (SS), and threshold voltage (V_{TH}) were measured, and the results were shown in Table 1 and FIG. 7.

**[Table 1]**

| **Classification** | **mobility (cm²/Vs)** | **Iₒₙ (µA)** | **log₁₀(Iₒₙ/I_{off})** | **I_{off} (pA)** | **SS (mV/decade)** | **V_{TH} (V)** |
|---|---|---|---|---|---|---|
| 99-RTFT | 6.34 | 0.65 | 5.43 | 2.44 | 182.44 | 1.30 |
| 90-RTFT | 44.20 | 7.69 | 4.90 | 25.31 | 1856.70 | 15.00 |
| 30-RTFT | 29.41 | 11.00 | 0.50 | 7.2(µA) | 46.28(V/decade) | - |
| 10-SPM-TFT | 25.01 | 2.12 | 6.27 | 1.20 | 204.29 | 1.55 |
| 70-SPM-TFT | 75.5 | 10.30 | 7.21 | 0.63 | 90.80 | 2.8 |
| Ag-MAC-TFT | 27.9 | 2.95 | 5.85 | 4.17 | 198.68 | 1.69 |

From the experimental results, the results that the off-state characteristics are not degraded and the on current and mobility increase, compared to comparative examples with uniform purity and density (99-RTFT, 90-RTFT, 30-RTFT), when a metallic single walled carbon nanotube with the purity of 70 wt% was additionally printed on the channel layer. Furthermore, the examples showed better results than the comparative example which formed the MAC region with Ag. Consequently, through the results of Experiment 1, it can be determined that the SPM-TFT according to one example of the present invention shows the most efficient effects as the on-off current ratio increases.

### (Experiment 2)

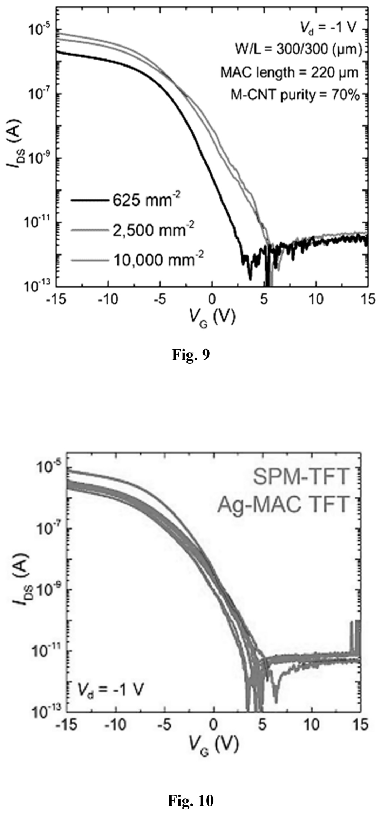

FIG. 8 is a graph showing a transfer curve according to the length of the MAC region, and FIG. 9 is a graph showing a transfer curve according to the ink drop density (DD).

In order to analyze the changes in performance depending on the length of the MAC region, transistors of which the total channel length was fixed to 300µm, and the length of the MAC region was 120, 170, 220 µm were manufactured. Referring to the graph of FIG. 8, it can be seen that the on-off current ratio increases as the length of the MAC region increases.

With this, in order to analyze the effects of the density of the metallic single walled carbon nanotube with the length of the MAC region fixed at 220µm, transistors were manufactured by changing the ink drop density of the ink comprising the metallic single walled carbon nanotube from 625/mm² to 10,000/mm². Referring to the graph of FIG. 8, it can be seen that the on-off current ratio increases, as the ink drop density increases.

By the two experimental results, it can be seen that the performance of the thin film transistor increases to the level at which an on-off current ratio value 70 times or higher compared to 99-RTFT, as the ink drop density increases.

### (Experiment 3)

FIG. 10 is a graph showing a transfer curve of the transistor in which Ag is printed in the MAC region and the transistor according to one example of the present invention. The transistor printed in the Ag MAC region can be called Ag-MAC-TFT. Referring to the graph of FIG. 10 and Table 1 above, it can be seen that the Ag-MAC-TFT shows lower performance than SPM-TFT. Herein, the SPM-TFT is a transistor which comprises a metallic single walled carbon nanotube with the purity of 70 wt% in the MAC region, and has the length of the MAC region of 220µm, and the length of the total channels of 300µm.

### (Experiment 4)

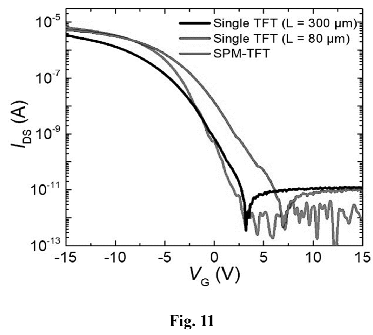

FIG. 11 is a graph showing a transfer curve of a single transistor and the transistor according to one example of the present invention.

The transistor according to one example of the present invention is SPM-TFT. Herein, the SPM-TFT is a transistor which comprises a metallic single walled carbon nanotube with the purity of 70 wt% in the MAC region, and has the length of the MAC region of 220µm, and the length of the total channels of 300µm.The single transistor may have the same channel length of 80µm as the length of the SDC region of the SPM-TFT.

Referring to the graph of FIG. 11, it can be seen that the SPM-TFT has the on-off current ratio value higher compared to the single transistor. In addition, in the single carbon nanotube transistor, the threshold voltage shift of 2V or more may occur due to a decrease in the percolation threshold as the channel is shortened, but the SPM-TFT does not have such a problem, and thus, it may be more suitable for commercialization. The reason why the SPM-TFT has the improved on-off current ratio value, and has no threshold voltage shift problem may be because additional Schottky barriers present between the SDC region and MAC region are formed, thereby inhibiting carrier transport when in the off-state.

The above description of the present invention is merely intended to illustratively describe the technical spirit of the present invention, and various changes and modifications can be made by those skilled in the art without departing from the essential features of the present invention. Therefore, the examples disclosed herein are not intended to limit the technical spirit of the present invention, but are intended to describe the present invention, and the scope of the technical spirit of the present invention is not limited by these examples. The protection scope of the present invention should be construed by the following claims, and all technical spirits within the equivalent scope thereto should be interpreted as being included in the scope of the present invention.

## Claims

1. A thin film transistor comprising a carbon nanotube channel layer, comprising
a substrate;
a source electrode and a drain electrode formed on the substrate;
a first channel layer comprising a first carbon nanotube located between the source electrode and drain electrode; and
a second channel layer comprising a second carbon nanotube formed on at least a portion of the first channel layer,
wherein the first carbon nanotube has lower conductivity than the second carbon nanotube.

2. The thin film transistor comprising a carbon nanotube channel layer according to claim 1,
wherein the first carbon nanotube and the second carbon nanotube are single walled carbon nanotubes, and
the carbon nanotubes of the first channel layer and the second channel layer form a network structure.

3. The thin film transistor comprising a carbon nanotube channel layer according to claim 1,
wherein the first channel layer has a semiconducting property, and
the second channel layer has a metallic property.

4. The thin film transistor comprising a carbon nanotube channel layer according to claim 1,
wherein the purity of the metallic carbon nanotube of the second channel layer is higher than the purity of the metallic carbon nanotube of the first channel layer.

5. The thin film transistor comprising a carbon nanotube channel layer according to claim 1,
wherein the second channel layer has a narrower bandgap than the first channel layer.

6. The thin film transistor comprising a carbon nanotube channel layer according to claim 1,
wherein the purity of the metallic carbon nanotube of the second channel layer is 60 wt% to 90 wt%.

7. The thin film transistor comprising a carbon nanotube channel layer according to claim 1,
wherein the second channel layer is formed to have a shorter length than the first channel layer in the central part.

8. The thin film transistor comprising a carbon nanotube channel layer according to claim 7,
wherein the length of the second channel layer is 50% to 90% of the length of the first channel layer.

9. A display device equipped with a circuit comprising a thin film transistor, comprising;
an insulating layer formed on a substrate; and
a pixel circuit array formed on the insulating layer;
wherein the array comprises a thin film transistor circuit comprising a carbon nanotube channel.

10. The display device equipped with a circuit comprising a thin film transistor according to claim 9,
wherein the insulating layer comprises at least one selected from the group consisting of PVP (polyvinylphenol), PVA (polyvinylalcohol), PMMA (polymethyl methacrylate), PVDF (Poly vinylidene fluoride), PVDF-TrFE (Poly vinylidene fluoride-trifluoroethylene), PVDF-HFP (Poly vinylidene fluoride-co-hexafluoropropylene) and SEBS (Styrene Ethylene/Butylene Styrene).

11. The display device equipped with a circuit comprising a thin film transistor according to claim 9,
wherein the thin film transistor comprising a carbon nanotube channel layer is the carbon nanotube thin film transistor of claim 1.

12. A manufacturing method of a thin film transistor comprising a carbon nanotube channel layer, comprising; forming an oxide layer on a substrate;
forming a first channel layer comprising a single walled carbon nanotube network on the upper part of the oxide layer;
forming a second channel layer comprising a metallic carbon nanotube on the first channel layer; and
forming a source electrode and a drain electrode on the oxide layer.

13. The manufacturing method of a thin film transistor comprising a carbon nanotube channel layer according to claim 12,
wherein the forming a first channel layer and the forming a second channel layer are performed by an inkjet printing process.

14. The manufacturing method of a thin film transistor comprising a carbon nanotube channel layer according to claim 12,
wherein the carbon nanotube comprised in the second channel layer is a single walled carbon nanotube network, and
the forming a first channel layer and the forming a second channel layer
increase the density of the carbon nanotube network of the channel layer by repeatedly performing a unit process consisting of an inkjet printing process and a cleaning process multiple times.

15. The manufacturing method of a thin film transistor comprising a carbon nanotube channel layer according to claim 12,
wherein the carbon nanotube thin film transistor is the carbon nanotube thin film transistor of claim 1.
